# EUROPÄISCHE PATENTSCHRIFT

(11) **EP 1 941 289 B1**
(45) Veröffentlichungstag und Bekanntmachung des Hinweises auf die Patenterteilung: **22.12.2010**
(21) Anmeldenummer: 06742355.8
(22) Anmeldetag: 17.05.2006
(51) Int. Cl.: G01R 31/36

(54) **VERFAHREN UND VORRICHTUNG ZUR BESTIMMUNG EINES ALTERUNGSZUSTANDS EINER BATTERIE**
METHOD AND DEVICE FOR DETERMINING THE AGEING OF A BATTERY
PROCEDE ET DISPOSITIF POUR DETERMINER L'ETAT DE VIEILLISSEMENT D'UN ACCUMULATEUR

(30) Priorität: 28.10.2005 DE 102005052862
(43) Veröffentlichungstag der Anmeldung: 09.07.2008
(73) Patentinhaber: TEMIC Automotive Electric Motors GmbH, 10553 Berlin (DE)
(72) Erfinder: BIRKE, Peter, 16548 Glienicke/Nordbahn (DE); MALIK, Manfred, 82377 Penzberg (DE); KELLER, Michael, 76534 Baden-Baden (DE)
(74) Vertreter: Büchner, Jörg
(86) Internationale Anmeldenummer: PCT/DE2006/000847
(87) Internationale Veröffentlichungsnummer: WO 2007/048367

(56) Entgegenhaltungen:
- EP-A- 0 864 876
- US-B1- 6 453 249
- PATENT ABSTRACTS OF JAPAN Bd. 018, Nr. 627 (P-1834), 29. November 1994 (1994-11-29) & JP 06 242192 A (OMRON CORP; others: 01), 2. September 1994 (1994-09-02)
- PATENT ABSTRACTS OF JAPAN Bd. 2002, Nr. 12, 12. Dezember 2002 (2002-12-12) & JP 2002 228730 A (SHIKOKU ELECTRIC POWER CO INC; JAPAN STORAGE BATTERY CO LTD), 14. August 2002 (2002-08-14)

## Beschreibung

Die Erfindung betrifft ein Verfahren und eine Vorrichtung zur Bestimmung eines Alterungszustands einer, insbesondere sekundären Batterie für ein Fahrzeug. Unter einer sekundären Batterie wird gegenüber einer nicht wieder aufladbaren primären Batterie ein wieder aufladbarer Speicher (auch Akkumulator oder Sekundärspeicher genannt) verstanden. Im Folgenden wird unter einer Batterie eine sekundäre Batterie verstanden. Als Fahrzeugbatterie wird insbesondere eine Blei-Batterie, eine Nickel-Metall-Hydrid-Batterie, eine Lithium-Ionen-Batterie oder eine andere geeignete wieder aufladbare Speichereinheit, wie ein Kondensator, verwendet. Unter dem Alterungszustand der Batterie wird insbesondere der Grad der Fähigkeit der Batterie verstanden, eine geforderte Leistung zur Verfügung zu stellen.

Ein Verfahren zur Bestimmung des Alterungszustands einer Fahrzeugbatterie wird insbesondere für Traktionsbatterien von Elektrofahrzeugen oder Hybridfahrzeugen angewendet, da diese durch Lagerung und Betrieb kontinuierlich altern. Insbesondere ist die mit zunehmender Gebrauchsdauer verbundene Reduzierung der speicherbaren Ladungsmenge und die Abnahme der Fähigkeit der Batterie, Leistung zur Verfügung zu stellen, von erheblicher Bedeutung für den Benutzer des Fahrzeugs.

Der Alterungszustand der Batterie wird üblicherweise durch Informationen, wie der Häufigkeitsverteilung aus kontinuierlichen Messungen von Spannung, Strom und Temperatur bestimmt. Dies führt unter Umständen zu einem großen Speicherbedarf der fortlaufend erfassten Messgrößen. Darüber hinaus ist der mit der Analyse der zeitlich erfassten Messgrößen verbundene Verarbeitungsaufwand sehr groß. Auch ist eine Anpassung des Analyseverfahrens auf geänderte Umgebungsbedingungen und eine daraus resultierende Rekalibrierung der Mess- und Analyseverfahren besonders zeit- und speicheraufwendig.

Die EP-A-0 864 876 offenbart ein Verfahren und eine Vorrichtung zum Bestimmen des Alterungszustands einer Batterie, bei denen ein bei einer bestimmten Temperatur und einer bestimmten Last gemessener Spannungsabfall mit einem gespeicherten Wert eines Standardspannungsabfalls für diese Temperatur und diese Last verglichen wird und anhand der Differenz dieser Werte der Alterungszustand bestimmt wird.

Der Erfindung liegt daher die Aufgabe zugrunde, ein besonders einfaches Verfahren zur Bestimmung eines Alterungszustands einer Batterie anzugeben. Darüber hinaus ist eine besonders geeignete Vorrichtung zur Bestimmung des Alterungszustands einer Batterie anzugeben.

Hinsichtlich des Verfahrens wird die Aufgabe erfindungsgemäß gelöst durch die Merkmale des unabhängigen Anspruchs 1. Die Aufgabe hinsichtlich der Vorrichtung wird erfindungsgemäß gelöst durch die Merkmale des unabhängigen Anspruchs 11.

Vorteilhafte Weiterbildungen sind Gegenstand der Unteransprüche.

Beim Verfahren zur Bestimmung eines Alterungszustands einer Batterie, insbesondere einer Nickel-Metall-Hydrid-Batterie oder Lithium-Ionen-Batterie für ein Fahrzeug, werden als Parameter der Batterie insbesondere Ladezustand, Temperatur, Ladestrom und/oder Entladestrom erfasst oder bestimmt, wobei jeweils zwei von den Parametern als Parameterpaar vorgegeben und derart zueinander in Beziehung gesetzt werden, dass dem jeweiligen Parameter zugrunde liegende Parameterbereiche und daraus resultierende Wertepaare des vorgegebenen Parameterpaares klassifiziert gewichtet werden. Eine derartige Klassifizierung und Wichtung von Messwertepaaren ermöglicht eine einfache und schnelle sowie speicherplatzsparende Analyse des Alterungszustands der Batterie, indem zeitlich erfasste Messwerte anhand von zueinander in Beziehung gesetzten Wertepaaren verarbeitet werden und daraus resultierend ein klassifizierter und/oder gewichteter Wert zur weiteren Analyse und Verarbeitung gebildet wird. Somit ist durch einfache Vergleichsrechnung ein Alterungsfaktor bestimmbar. Zudem kann anhand der Werte des Alterungsfaktors der Alterungszustand Batterie in vorgegebene Fehlermodes differenziert werden. Dies ermöglicht eine weitere Reduzierung des Speicherbedarfs und des Analyseaufwands.

Dabei wird für eine einfache Analyse des Batteriezustands über einen vorangegangenen Zeitraum bei Vorliegen von aktuellen Istwerten oder Momentanwerten, die einem der vorgegebenen Wertepaare entsprechen, ein dem betreffenden Wertepaar zugeordneter Zustandszähler erhöht. Hierdurch ist eine einfache Berücksichtigung des vorangegangenen Lebens- oder Betriebsalters der Batterie bei der Bestimmung des aktuellen Alterungszustands ermöglicht. Dabei ist anstelle der aufwendigen Hinterlegung einer Vielzahl von Messwerten und deren Erfassungszeitpunkten beim erfindungsgemäßen Verfahren lediglich ein Wert eines Zustandszählers hinterlegt.

Um zusätzlich oder alternativ zur einfachen Identifizierung von Fehlermodes der Batterie den Alterungszustand der Batterie bestimmen zu können, wird anhand des Wichtungsfaktors und des Zustandszählers für alle Wertepaare eines Parameterpaares ein einzelner Alterungsfaktor bestimmt. Dieser Alterungsfaktor, der für ein jeweiliges Parameterpaar, z. B. Ladezustand und Temperatur, Temperatur und Selbstentlade-Umsatz, Ladezustand und Ladeumsatz, Ladestrom und Ladeumsatz, Zeit und Ladeumsatz, gebildet wird, gibt dabei den Einfluss des jeweiligen Parameterpaares auf die Alterung der Batterie wieder. Je nach Grad des Einflusses des jeweiligen Parameterpaares und deren Werte kann der jeweilige Alterungsfaktor eines Parameterpaares gewichtet werden.

Vorzugsweise wird ein jeder Parameter derart klassifiziert, dass dessen, insbesondere zulässiger Parameterbereich in eine vorgegebene Anzahl von Klassen unterteilt wird. Die Anzahl der Klassen wird dabei bestimmt durch den jeweiligen Einfluss und die Wirkung des betreffenden Parameters auf den Alterungszustand der Batterie. So weist eine Batterie ein sehr stark temperaturabhängiges Verhalten auf. Insbesondere hängen die Kapazität und der Ladezustand einer Nickel-Metall-Hydrid-Batterie (kurz auch NiMH-Batterie genannt) aufgrund der in der negativen Elektrode eingesetzten Wasserstoffspeicherlegierung stark von der Umgebungstemperatur ab. Hohe Temperaturen von > 45°C führen zur Wasserstoffabgabe und zur Beeinträchtigung der Ladefähigkeit durch die negative Elektrode, da mit steigender Temperatur ein Wasserstoffgegendruck aufgebaut wird. Bei sehr niedrigen Temperaturen von < -10°C wird Wasserstoff mit einer schlechteren Aus- und Einbaukinetik von der negativen Elektrode abgegeben und aufgenommen. Mit anderen Worten: Bei Metallhydridspeicher-Legierungen wird Wasserstoff bei Raumtemperatur gut in einer solchen Legierung gebunden, aber durch Wärme mehr und mehr wieder ausgetrieben. Daher wird beispielsweise der Parameterbereich des Ladezustands und/oder der Temperatur in sieben bzw. in acht Klassen mit einer vorgegebenen Schrittweite von 5% bis 20% bzw. von 5°C bis 20°C in einem Parameterbereich von < 30% bis > 95% bzw. < -25°C bis > 55°C unterteilt.

Um anstelle des umfangreichen Rechenaufwands von gespeicherten Messwerten durch einfachen Vergleich von Istwerten mit hinterlegten Werten eine Aussage über den Alterungszustand der Batterie zu erhalten, wird einem jeden Wertepaar eines Parameterpaares klassenbezogen ein Wichtungsfaktor zugeordnet. Werden beispielsweise als Parameterpaar der Ladezustand und die Temperatur in Beziehung zueinander gesetzt und deren Parameterbereiche in Klassen unterteilt, so wird jedes Wertepaar, z. B. Ladezustand < 30% und Temperatur < -25°C oder Ladezustand > 95% und Temperatur > 55°C mit einem zugehörigen Wichtungsfaktor versehen. Der Wichtungsfaktor entspricht dabei dem anhand von Erfahrungswerten und insbesondere mittels eines Batteriemodells ermittelten Alterungsfaktor der zueinander in Beziehung gesetzten Parameter - Ladezustand und Temperatur - und deren Einfluss auf die Alterung der Batterie.

Zweckmäßigerweise werden diejenigen Wertepaare mit einem hohen Wichtungsfaktor als die Lebensdauer der Batterie beeinflussende Daten klassifiziert. Diese Wertepaare mit hohem Wichtungsfaktor können darüber hinaus als Fehlermodes identifiziert werden. Unter Fehlermodes werden dabei im Folgenden insbesondere die Lebensdauer der Batterie wesentlich beeinflussenden Ereignisse verstanden, die diejenigen Parameterbereiche darstellen, die mit einer hohen Wichtung belegt sind.

Alternativ oder zusätzlich werden diejenigen Wertepaare mit einem niedrigen Wichtungsfaktor als funktionsrelevante oder betriebsgemäße Daten klassifiziert. Dabei handelt es sich um jene Wertepaare, die im normalen und betriebszulässigen Parameterbereich liegen, und die eine durchschnittliche oder nur geringe Alterung der Batterie bewirken.

Darüber hinaus wird vorzugsweise anhand der Summe der gewichteten einzelnen Alterungsfaktoren aller Parameterpaare ein Gesamt-Alterungsfaktor für die Batterie bestimmt. Zur Berücksichtigung aller die Alterung der Batterie beeinflussenden Parameter wird oder werden der oder die einzelnen Alterungsfaktoren und/oder der Gesamt-Alterungsfaktor bei der Ermittlung des Alterungszustands der Batterie verwendet.

In einer weiteren Ausführungsform der Erfindung kann der Alterungszustand bei der Ermittlung der Funktionsfähigkeit der Batterie berücksichtigt werden. Für einen möglichst schonenden Betrieb der Batterie können die Werte des Alterungszustands, des Ladezustands und/oder der Funktionsfähigkeit der Batterie einem Steuergerät zugeführt werden. Dabei werden die Werte bei einem im Steuergerät hinterlegten Batteriemanagement zur Einstellung von Ladevorgängen bzw. Entladevorgängen der Batterie in einem optimalen Arbeitspunkt berücksichtigt. Hinsichtlich der Vorrichtung zur Bestimmung eines Alterungszustands einer Batterie umfasst diese einen Speicher, in welchem mehrere Parameter der Batterie derart hinterlegt sind, dass jeweils zwei von den Parameter als Parameterpaar zueinander in Beziehung gesetzt sind und dem jeweiligen Parameter zugrunde liegende Parameterbereiche und daraus resultierende Wertepaare des vorgegebenen Parameterpaares klassifiziert gewichtet sind. Eine derartige Hinterlegung eines kombinierten Wertes für Wertepaare anstelle der Hinterlegung von einzelnen Werten und deren Erfassungszeiten ermöglicht eine deutliche Reduzierung des Speicherplatzes und eine schnellere Analyse und Auswertung der hinterlegten Daten anhand von aktuellen Daten, wie Istwerten und Momentanwerten.

Für ein schnelles Auffinden von die Alterung der Batterie beeinflussenden Parametern sind für ein jeweiliges Parameterpaar mehrere Speichereinheiten vorgesehen. Zweckmäßigerweise ist in einer ersten Speichereinheit eine einer vorgegebenen Anzahl von Klassen entsprechende Anzahl von Speicherfeldern für einen Parameter vorgesehen. In einer zweiten Speichereinheit ist für ein jeweiliges Parameterpaar eine Anzahl von Speicherfeldern für einen Wichtungsfaktor vorgesehen. Darüber hinaus ist zur Berücksichtigung der vorangegangenen Werte einem jeden hinterlegten Wertepaar ein Zustandszähler zugeordnet, anhand dessen die Häufigkeit des Auftretens des Wertepaares erfasst wird. Somit sind anstelle von einem umfangreichen Speicherplatzbedarf zur Hinterlegung einer Vielzahl von einzelnen Messwerten und deren Erfassungszeitpunkten lediglich der Speicherplatz für einen Wichtungsfaktor und einen Zustandszähler erforderlich.

Die mit der Erfindung erzielten Vorteile bestehen insbesondere darin, dass durch Klassifizierung und Wichtung von Parameterbereichen von zwei zueinander in Beziehung gesetzten Parametern, welche die Alterung der Batterie beeinflussen, eine einfache und schnelle Möglichkeit zur Ermittlung des Alterungszustands der Batterie anhand der Identifizierung von Fehlzuständen der Batterie gegeben ist. Darüber hinaus ist durch die Wichtung und Klassifizierung von Parameterbereichen einzelner die Lebensdauer der Batterie beeinflussenden Parameter eine einfache und schnelle Anpassung des Verfahrens an geänderte Umgebungsbedingungen möglich. Insbesondere kann durch Änderung der Wichtung und der Klassen die Batterie an die neuen und geänderten Umgebungsbedingungen angepasst und auf diese neu kalibriert werden. Das Verfahren ist dabei unabhängig vom Batterietyp oder von der Batterietechnologie einfach adaptierbar. Durch die Vorgabe der Anzahl von Fehlermodes und der Anzahl der Klassen der einzelnen Parameter ist eine an den jeweiligen Typ und die jeweilige Technologie angepasste Bestimmung des Alterungszustands der Batterie ermöglicht. Die vorgegebene Wichtung der Wertepaare zweier Parameter berücksichtigt dabei den Batterietyp bzw. die Batterietechnologie bzw. die vorangegangene Lebensdauer anhand von Expertenwissen. Zustandsverbesserungen der Batterie, z. B. durch Ausgleichsladungen, können einfach und schnell berücksichtigt werden, indem der betreffende Wichtungsfaktor angepasst wird.

Ausführungsbeispiele der Erfindung werden anhand einer Zeichnung näher erläutert. Darin zeigen:
- Fig. 1: schematisch eine Vorrichtung zur Bestimmung eines Alterungszustands einer Batterie,
- Fig. 2: schematisch ein Batteriemanagementsystem mit einer Vorrichtung zur Bestimmung des Alterungszustands der Batterie,
- Fig. 3 bis 4: eine Ausführungsform für einen Speicher zur Hin- terlegung von klassifiziert gewichteten Parameter- paaren,
- Fig. 5 bis 6: eine Ausführungsform für Speichereinheiten zur Klassifizierung von Parametern und zur Hinterlegung von Wichtungsfaktoren, und
- Fig. 7 bis 11: weitere Ausführungsformen für Speicher zur Hin- terlegung weiterer klassifiziert gewichteter Para- meterpaare.

Einander entsprechende Teile sind in allen Figuren mit den gleichen Bezugszeichen versehen.

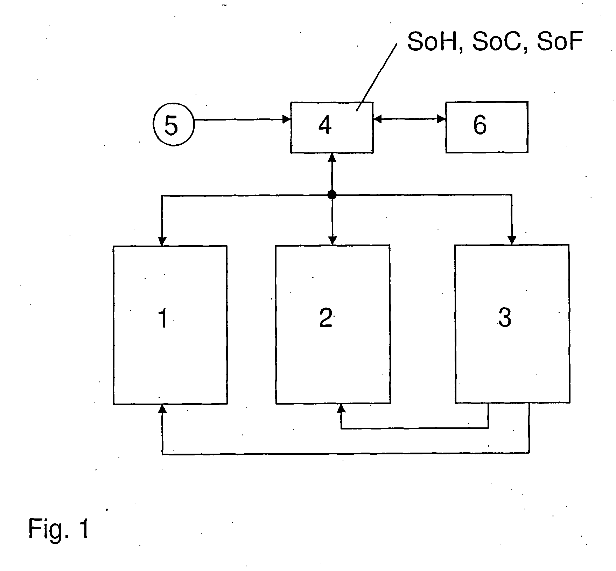

Figur 1 zeigt eine Vorrichtung zur Bestimmung eines Alterungszustands SoH einer Batterie 1 für ein Fahrzeug. Bei der Batterie 1 kann es sich um eine Traktionsbatterie für ein Hybridfahrzeug handeln. Als Traktionsbatterie wird beispielsweise eine Nickel-Metall-Hydrid-Batterie, eine Lithium-Ionen-Batterie oder eine andere geeignete Batterie eingesetzt. Darüber hinaus kann eine weitere Sekundärbatterie 2 in Form einer Bleisäurebatterie vorgesehen sein. Über einen Generator 3 werden die Batterien 1 und 2 während der Fahrt geladen.

Zur Steuerung der Batterien 1 und 2 umfasst die Vorrichtung ein Steuergerät 4, beispielsweise ein Batteriesteuergerät oder ein Bordnetzsteuergerät, das mit der Batterie 1 und der Sekundärbatterie 2 sowie dem Generator 3 verbunden ist. Mittels des Steuergeräts 4 werden als Parameter 5.1 bis 5.n der Batterie 1 und der Sekundärbatterie 2 beispielsweise Spannung U, Temperatur T, Strom I, Ladezustand SoC, Lade- und Entladezeiten t, erfasst und bestimmt.

Hierzu sind entsprechende Sensoren vorgesehen, deren Messwerte dem Steuergerät 4 zugeführt werden. Alternativ oder zusätzlich können Daten oder Informationen aus vorangegangenen Mess- und Verarbeitungsverfahren, z. B. Schätz- und Beobachtungsverfahren, Modell- und Parameteridentifikationsverfahren, Temperaturmodellverfahren, Historientabellen, Impedanzmessungen, selbst lernende Verfahren zuführt werden. Als Temperatur wird insbesondere die Umgebungstemperatur erfasst. Alternativ oder zusätzlich kann als Temperatur auch die jeweilige Batterie- oder Zellentemperatur erfasst werden.

Ferner sind zur Bestimmung des Alterungszustands SoH der Batterie 1 bzw. 2 weitere Informationen und Daten erforderlich, wie z. B. Oberflächenpassivierung der Elektroden der Batterie, schleichende Austrocknung der Batteriezellen, Kontaktverluste und durch diese Vorgänge bedingte Erhöhung von Zellimpedanzen sowie Abnahme der Batteriekapazität bezogen auf die gleiche Entladeschlussspannung. Diese Informationen und Daten können indirekt, beispielsweise über die Messung der Zellimpedanz, erfasst und dem Steuergerät 4 zugeführt und bei der Bestimmung des Alterungszustands SoH mittels eines modellbasierten Schätzverfahrens berücksichtigt werden. Auch können Ladezustandsabweichungen einzelner Batteriezellen innerhalb einer Serienschaltung berücksichtigt werden, wobei eine durch Ausgleichsladung bewirkte Aufhebung der Abweichungen mittels des Steuergeräts 4 anhand von Algorithmen bestimmt und berücksichtigt wird.

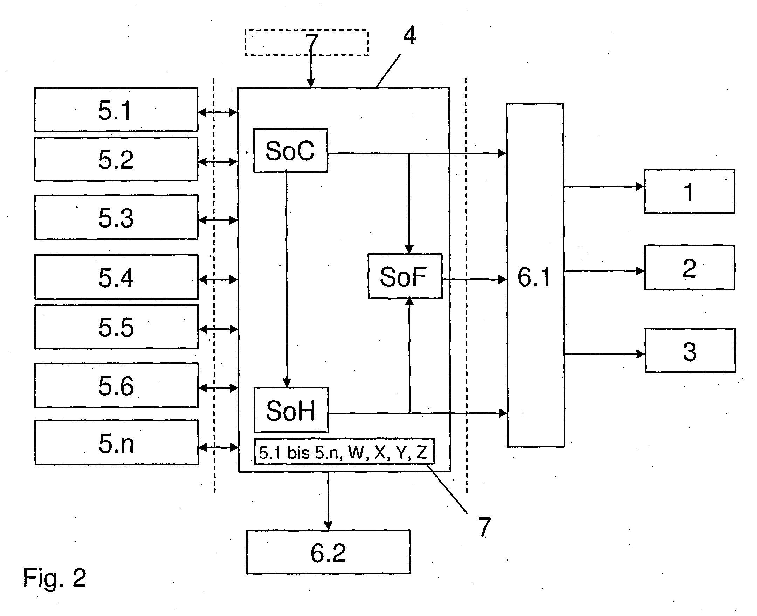

Zur Berücksichtigung weiterer fahrzeugrelevanter oder batterierelevanter Parameter, z. B. Fahrzeuggeschwindigkeit oder Werte für eine Bremsenergierekuperation, kann das Steuergerät 4 beispielsweise mit anderen Steuergeräten 6, mit einem Hybridsteuergerät 6.1 und/oder mit einer Lüftersteuerung 6.2, wie dies beispielhaft in Figur 2 dargestellt ist, verbunden sein.

Im herkömmlichen Betrieb eines Fahrzeugs wird die Batterie für eine ausreichende Versorgung der elektrischen Verbraucher, wie Zündung, Kraftstoffeinspritzung, Beleuchtung, Heizung, Klimaanlage, Bremsen fortlaufend auf ihren Ladezustand SoC, die momentane Temperatur T, den Entladestrom Ia und den Ladestrom Ie überwacht.

Zur Reduzierung des Speicherplatzbedarfs und für eine einfache und schnelle Bestimmung des Alterungszustands SoH der Batterie 1 ist erfindungsgemäß mindestens ein Speicher 7 vorgesehen, der separat ausgebildet oder im Steuergerät 4 integriert ist.

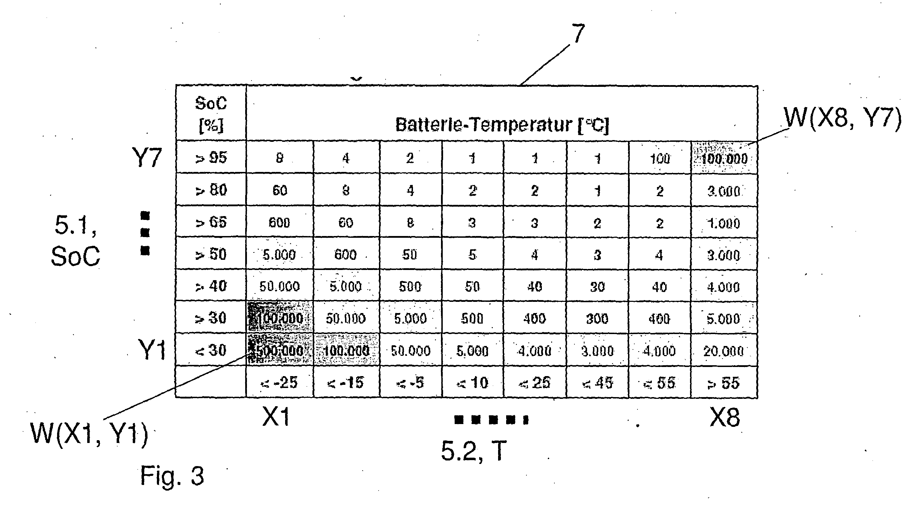

Ein Ausführungsbeispiel für den Aufbau des Speichers 7 ist in Figur 3 näher dargestellt. Im Speicher 7 sind dabei zwei Parameter 5.1 und 5.2, z. B. der Ladezustand SoC und die Temperatur T, als Parameterpaar zueinander in Beziehung gesetzt. Dabei sind für den jeweiligen Parameter 5.1 bzw 5.2 deren Parameterbereiche in eine vorgegebene Anzahl von Klassen Y1 bis Y7 bzw. X1 bis X8 unterteilt. Beispielsweise sind für den Parameter 5.1 - dem Ladezustand SoC - sieben Klassen Y1 bis Y7 für folgende Parameterbereiche < 30 %, > 30 %, > 40 %, > 50 %, > 65 %, > 80 % und > 95 %. Für den Parameter 5.2 - der Temperatur T - acht Klassen X1 bis X8 mit folgenden Parameterbereichen: < -25 °C, < -15 °C, < -5 °C, < 10 °C, < 25 °C, < 45 °C, < 55 °C und > 55 °C.

Die Parameterbereiche der beiden Parameter 5.1 und 5.2 sind dabei derart gewählt und vorgegeben, dass diese in die Lebensdauer der Batterie 1 sehr beeinflussende Klassen X1, X2, X7, Y1, Y2, Y8 und in funktionsrelevante Klassen X5, X6 und Y4 bis Y6 unterteilt sind. Je nach Batterietyp, -technologie, Umgebungsbedingungen und/oder Lebensalter der Batterie 1 können die Anzahl der Klassen X1 bis Xn bzw. Y1 bis Ym sowie deren Stufen, d.h. die Parameterbereiche, geändert und dynamisch angepasst werden.

Jedem Wertepaar X1, Y1 bis Xn, Ym der in Beziehung zueinander gesetzten Parameter 5.1 und 5.2 wird dabei ein Wichtungsfaktor W(X1, Y1; ...; Xn, Ym) zugeordnet. Der Wichtungsfaktor W entspricht dabei dem Alterungseinfluss der Parameter 5.1 und 5.2 auf die Batterie 1. Der Wichtungsfaktor W basiert auf Expertenwissen und kann an den jeweiligen Batterietyp, die Batterietechnologie oder an andere Bedingungen angepasst werden.

Dabei werden diejenigen Wertepaare X1, Y1; X1, Y2; X2, Y1; X8, Y7; mit einem hohen Wichtungsfaktor W von beispielsweise 100.000 bewertet. Die betreffenden Wertepaare X1, Y1; X1, Y2; X2, Y1; X8, Y7; stellen dabei Wertebereiche dar, welche die Lebensdauer der Batterie 1 stark beeinflussen. Diese die Lebensdauer der Batterie 1 stark beeinflussenden Wertepaare X1, Y1; X1, Y2; X2, Y1; X8, Y7; können darüber hinaus als Fehlermodes identifiziert werden.

Dabei wird bei Auftreten von Momentan- oder Istwerten der Parameter 5.1 und 5.2, die den betreffenden Wertepaare X1, Y1; X1, Y2; X2, Y1; X8, Y7; entsprechen, anhand der Zuordnung der Istwerte zu den Wertepaaren X1, Y1; X1, Y2; X2, Y1; X8, Y7; ein zugehöriger Fehlermode identifiziert.

Als Fehlermodes werden beispielsweise folgende Zustände von Wertepaaren X1, Y1 bis Xn, Ym identifiziert.

Folgende Fehlermodes für eine Metall-Hydrid-Batterie können auftreten:
I. Hohe Temperatur T und hoher Ladezustand SoC von bis 100 % (= Fehlermode I) oder
II. Hoher Ladestrom Ie und hoher Ladezustand SoC (= Fehlermode II) führen zu:
   1. O₂-Entwicklung an der positiven Elektrode, Ni(OH)₂;
   2. H₂-Entwicklung an negativer Elektrode, Speicherlegierung;
   3. O₂- und H₂-Entwicklung (Knallgas);
   4. Hoher Selbstladung.

   Hierdurch kann es zu folgenden irreversiblen Ereignissen an der Batterie 1 kommen:
   - Oxidation der negativen Elektrode;
   - Oxidation des Separators;
   - Austrocknung (H2O-Verlust), falls Überdruckventil öffnet, Kapazitätsverlust;
   - Anstieg Innenwiderstand;
   - Hitzeschäden;
   - Explosion;

   Darüber hinaus können reversible Ereignisse in Folge auftreten:
   - Kapazitätsverlust;
   - Ladewirkungsgrad sinkt.
III. Hohe Temperatur T und Ladezustand SoC < 80 % (= Fehlermode III) führen zur:
   1. Korrelation Ladeende (="Spannungsbuckel") mit niedrigeren Ladezuständen SoC;
   2. Selbstentladung.

   Hierdurch kann es zu reversiblen Schäden kommen:
   - verfügbare Kapazität sinkt;
   - Ladewirkungsgrad sinkt.
IV. Niedrige Temperatur T und moderate Belastung der Batterie (= Fehlermode IV) führen zu:
   1. einer starken Hemmung der Speicherlegierung der negativen Elektrode (Kinetik stark gehemmt);
   2. Polarisationen an Phasengrenze Elektrode/Elektrolyt/Separator.

   Hierdurch kann es zu reversiblen Schäden kommen:
   - Laden/Entladen schwierig.
V. Niedrige Temperatur T und hoher Strom (= Fehlermode V) führen zur:
   1. Schädigung der Speichermetallmatrix.

   Hierdurch kann es zu irreversiblen und reversiblen Schäden kommen :
   - Verfügbare Kapazität sinkt;
   - Gleichgewicht Rekombinationszyklus gestört;
   - O₂-Entwicklung an der positiven Elektrode.
VI. Überhöhter Strom (Fehlermode VI) führen zur:
   1. Polarisation;
   2. Verlustleistung.

   Hierdurch kann es zu irreversiblen und reversiblen Schäden kommen:
   - Schädigung der Gitterstruktur der Speicherelektroden;
   - Überhitzung der Zellen (reversibel/irreversibel);
   - Schädigung der zellinternen und externen Verbinder.
VII. Sehr tiefer Ladezustand SoC (= Fehlermode VII) oder
VIII. Hoher Entladestrom und niedriger Ladezustand SoC (= Fehlermode VIII) führen zur:
   1. Tiefentladung;
   2. Überentladung.

   Hierdurch kann es zu irreversiblen und reversiblen Schäden kommen:
   - bei kurzer Tiefentladung zu reversiblen Schäden;
   - bei langer Tiefentladung zur Schädigung der Leitfähigkeitsmatrix der positiven Elektrode (= irreversible Schädigung);
   - kurzer Umpolung (reversibel);
   - längere Umpolung (irreversibel);
   - Gefahr der Überhitzung;
   - Knallgasentwicklung;
   - Aktivierung des Sicherheitsventils.
IX. Bauteiltoleranzen führen zum:
   1. Auseinanderlaufen der Ladezustände SoC der Einzelzellen der Batterie einer Serienverschaltung.

   Hierdurch kann es zu irreversiblen und reversiblen Schäden kommen:
   - bei kurzer Tiefentladung zu reversiblen Schäden;
   - bei langer Tiefentladung zur Schädigung der Leitfähigkeitsmatrix der positiven Elektrode (= irreversible Schädigung);
   - kurzer Umpolung (reversibel);
   - längere Umpolung (irreversibel);
   - Gefahr der Überhitzung;
   - Knallgasentwicklung;
   - Aktivierung des Sicherheitsventils;
   - Einzelzellen können einen Ladezustand SoC von 100 % bei Ladevorgängen überschreiten.

Diese als Fehlermodes I bis IX identifizierten Zustände der Batterie 1 werden anhand der Wertepaare X1, Y1 bis Xn, Ym der Parameter 5.1 und 5.2, insbesondere der Temperatur T und des Ladezustands SoC mit einem hohen Wichtungsfaktor W von beispielsweise 100.000 und 500.000 bewertet.

Die Hinterlegung der Klassen Y1 bis Ym und X1 bis Xn sowie der Wichtungsfaktoren W im Speicher 7 erfolgt dabei lediglich anhand von Integerzahlen. Beispielsweise für den Wichtungsfaktor W in einem Bereich von 1 bis 500.000.

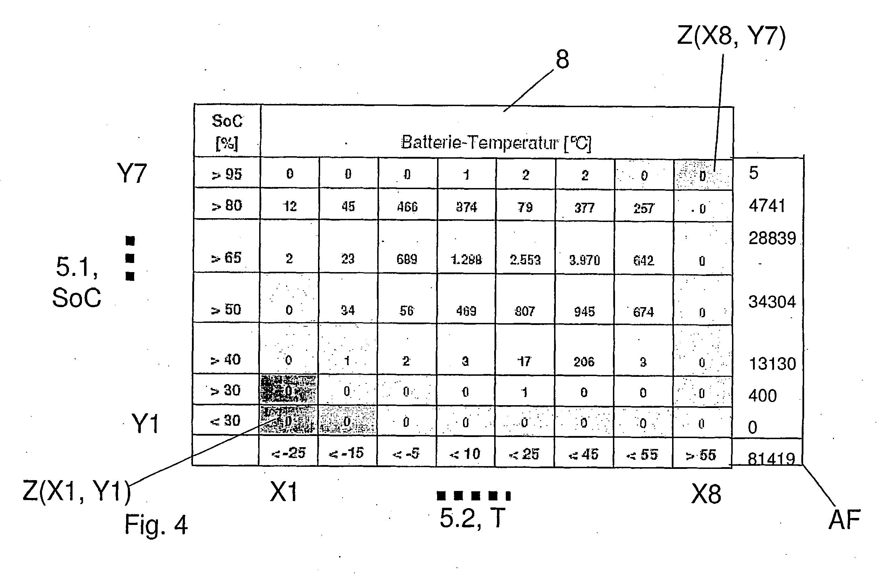

In einem weiteren Speicher 8, der in Figur 4 näher dargestellt ist, sind für die Wertepaare X1 Y1 bis Xn, Ym der in Beziehung zueinander gesetzten Parameter 5.1 und 5.2 zugehörige Zustandszähler Z(X1, Y1; ...; Xn, Ym) hinterlegt. Der Zustandszähler Z dient dabei der Berücksichtigung der vorangegangenen Zustände der Batterie 1 und somit der Historie der Zustände der Batterie 1. Dabei wird bei Vorliegen von Momentanwerten oder Istwerten der Parameter 5.1 und 5.2, die einem der vorgegebenen Wertepaare X1, Y1 bis Xn, Ym entsprechen, der dem betreffenden Wertepaar X1 Y1 bis Xn, Ym zugehörige Zustandszähler Z (X1, Y1; ...; Xn, Ym) erhöht. Mit anderen Worten: Je häufiger ein Zustand aufgetreten ist, desto höher ist der Zählerstand des betreffenden Zustandszählers Z. In Figur 4 weist beispielsweise das Wertepaar X6, Y5 den höchsten Zählerstand mit 3.970 auf.

Um den Einfluss des Auftretens der Wertepaare X1 Y1 bis Xn, Ym auf die Lebensdauer und den Alterungszustand SoH der Batterie bestimmen zu können, sind im Speicher 8 weitere Speicherfelder zur Ermittlung eines diesem Parameterpaar 5.1 und 5.2 zugehörigen Alterungsfaktors AF zu bestimmen. Dazu werden der jeweilige Wichtungsfaktor W(X1, Y1; ...; Xn, Ym) mit dem zugehörigen Zustandszähler Z(X1, Y1; ...; Xn, Ym) multipliziert und deren Summe gebildet. Der so gebildete Alterungsfaktor AF entspricht dem Alterungseinfluss der betrachteten Parameter 5.1 und 5.2 auf die Batterie 1.

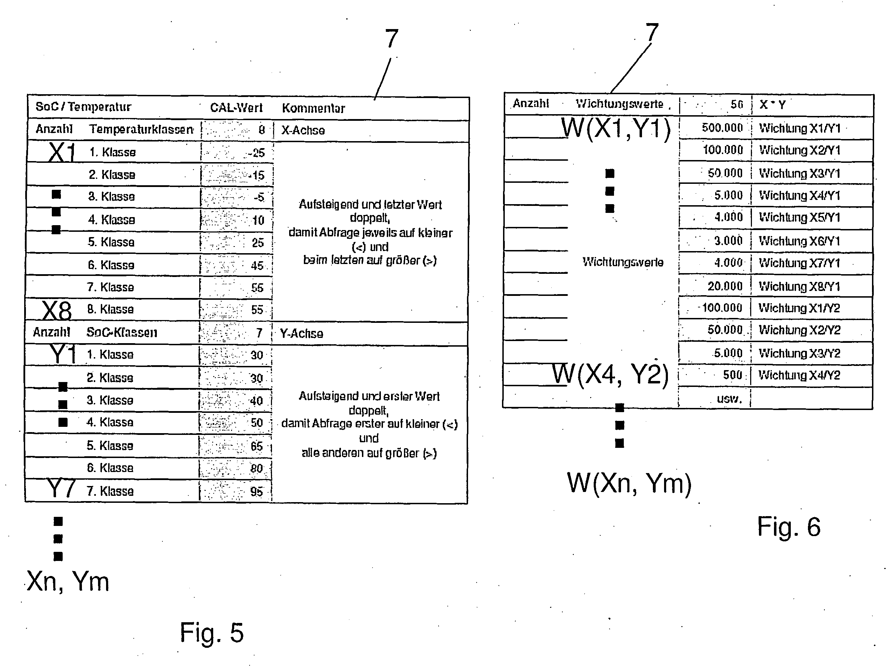

Figuren 5 und 6 zeigen im Detail die Speicherfelder des Speichers 7 zur Vorgabe und Ermittlung der Klassen X1 bis Xn bzw. Y1 bis Ym der betrachteten Parameter 5.1 und 5.2 bzw. zur Vorgabe und Ermittlung der Werte der zugehörigen Wichtungsfaktoren W(X1, Y1 bis Xn, Ym).

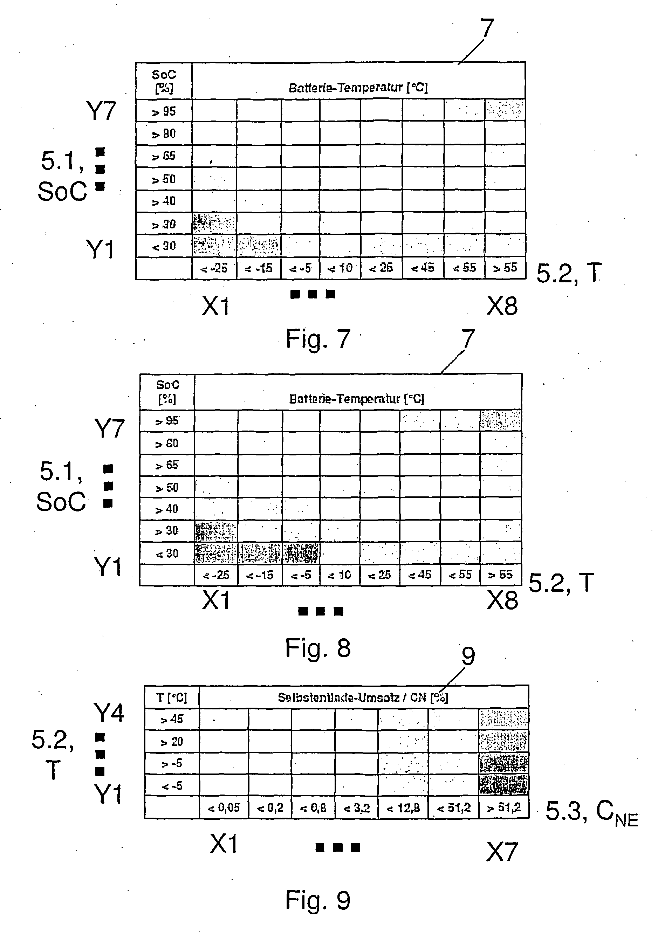

Die Figuren 7 und 8 zeigen verschiedene Ausführungsformen des Speichers 7, welche auf unterschiedliche Betriebsmode der Batterie 1 zurückzuführen sind.

So sind in Figur 7 beispielhaft die Zuordnung von Ladezustand SoC und Temperatur T und die betreffenden Fehlermodes im Normalbetrieb der Batterie 1 dargestellt. Dabei wird bei Auftreten einer der Wertepaare X1, Y1; X1, Y2; X2, Y1 oder X8, Y7 ein Fehlermode identifiziert. Zur Überwachung der Batterie 1 werden im Normalbetrieb mindestens alle 0,5 h aktuelle Istwerte der Parameter 5.1 und 5.2 erfasst und bestimmt.

Figur 8 zeigt ein Ausführungsbeispiel für eine Batterie 1 im Wakeup-Modus. Zusätzlich zu den im Normalbetrieb vorgegebenen Fehlermodes wird im Wakeup-Modus bei Auftreten des Wertepaares X3, Y1 ein Fehlermode identifiziert. Im Wakeup-Modus werden die aktuellen Istwerte der Parameter 5.1 und 5.2 mindestens alle 1,0 h erfasst und bestimmt.

Die Figuren 9 bis 11 zeigen weitere Ausführungsbeispiele für Parameterpaare 5.1 bis 5.n, die zueinander in Beziehung gesetzt, klassifiziert und gewichtet werden und für die jeweils ein Alterungsfaktor AF bestimmt wird. Zusätzlich kann der einzelne Alterungsfaktor AF eines jeden Parameterpaares 5.1 bis 5.n gewichtet werden. Die Summe aller einzelnen und gegebenenfalls gewichteten Alterungsfaktoren AF aller Parameterpaare 5.1 bis 5.n ergibt den Gesamt-Alterungsfaktor gAF, der den Alterungszustand SoH der Batterie 1 repräsentiert.

In Figur 9 ist beispielhaft als weiteres Parameterpaar 5.2 und 5.3 - die Temperatur T und der Selbstentlade-Umsatz C_{NE} in einem weiteren Speicher 9 hinterlegt. Diese Parameterbeziehung dient der Identifizierung von Fehlermodes und deren Einflüsse auf die Alterung der Batterie 1 im Ruhemodus der Batterie 1, wenn diese beispielsweise zwischen zwei Wakeup-Moden im Ruhemodus ist. Für dieses betrachtete Parameterpaar 5.2 und 5.3 wird als Fehlermode eine Ruhestrombelastung identifiziert.

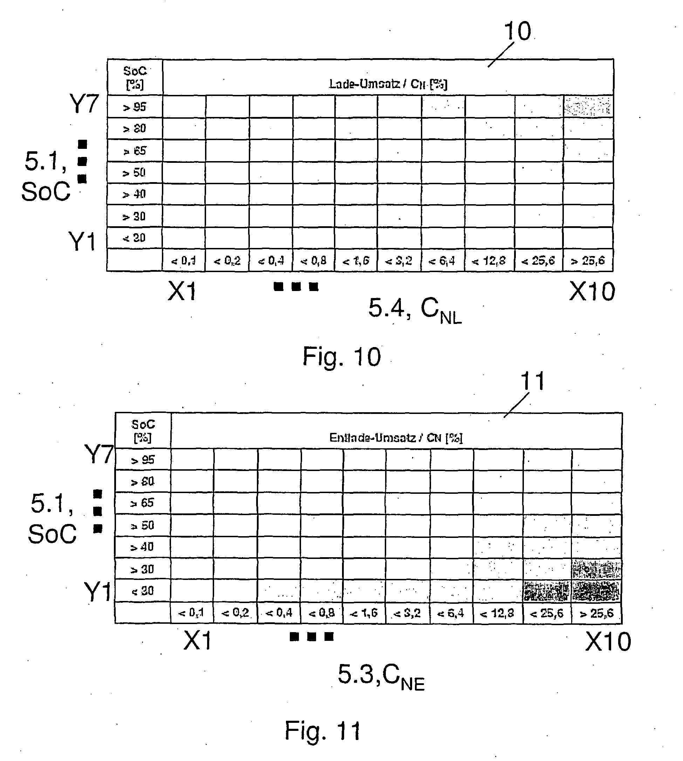

In Figur 10 ist beispielhaft als weiteres Parameterpaar 5.4 und 5.1 - der, Lade-Umsatz C_{NL} und der Ladezustand SoC - in einem weiteren Speicher 10 hinterlegt. Diese Parameterbeziehung dient der Identifizierung von Fehlermodes und deren Einflüsse auf die Alterung der Batterie 1 beim Laden der Batterie 1, wenn diese beispielsweise zwischen zwei Entladungen wieder geladen wird. Dabei wird der integrierte Lade-Umsatz C_{NL} zwischen zwei Entladungen mit dem Ladezustand SoC der Batterie 1 in Beziehung zueinander gesetzt. Für dieses betrachtete Parameterpaar 5.4 und 5.1 wird als Fehlermode ein Überladen oder eine Ermüdung identifiziert (= Wertepaar X10, Y7).

Darüber hinaus können weitere Parameterbeziehungen und deren Einfluss auf die Alterung der Batterie 1 berücksichtigt werden. Beispielsweise können in weiteren Speichern folgende Parameterpaare beim Laden der Batterie 1 berücksichtigt werden:
- maximaler Ladestrom während des Ladeumsatzes;
- durchschnittlicher Ladestrom während des Ladeumsatzes;
- Zeitbereich des Ladeumsatzes;
- Maximaler Ladestrom in Abhängigkeit von der Temperatur.

Für die zusätzlichen oder alternativ betrachteten Parameterpaare werden wiederum Fehlermodes vorgegeben und anhand der aktuell erfassten Istwerte schnell und einfach identifiziert.

In Figur 11 ist beispielhaft als weiteres Parameterpaar 5.3 und 5.1 - der Lade-Umsatz C_{NE} und der Ladezustand SoC - in einem weiteren Speicher 11 hinterlegt. Diese Parameterbeziehung dient der Identifizierung von Fehlermodes und deren Einflüsse auf die Alterung der Batterie 1 beim Entladen der Batterie 1, wenn diese beispielsweise zwischen zwei Ladungen wieder entladen wird. Dabei wird der integrierte Entlade-Umsatz C_{NE} bzw. die Höhe der Entladetiefe DoD (DoD = depth of discharge) zwischen zwei Ladungen mit dem Ladezustand SoC der Batterie 1 in Beziehung zueinander gesetzt. Für dieses betrachtete Parameterpaar 5.3 und 5.1 wird als Fehlermode ein Tiefentladen, ein Überentladen oder eine Ermüdung identifiziert (= Wertepaar X9, Y1; X10, Y1; X10, Y2). Bei Bleibatterien reduzieren sich mit steigender Entladetiefe DoD die Lebensdauer beträchtlich, z. B. 100% DoD 500 Zyklen oder 5 % DoD 50000 Zyklen.

Beim Entladen der Batterie 1 können darüber hinaus weitere Parameterbeziehungen und deren Einfluss auf die Alterung der Batterie 1 berücksichtigt werden:
- maximaler Entladestrom während des Entladeumsatzes;
- durchschnittlicher Entladestrom während des Entladeumsatzes;
- Zeitbereich des Entladeumsatzes;
- Maximaler Entladestrom in Abhängigkeit von der Temperatur.

Für die zusätzlichen oder alternativ betrachteten Parameterpaare werden wiederum Fehlermodes vorgegeben und anhand der aktuell erfassten Istwerte schnell und einfach identifiziert.

Zur Berücksichtigung von Bauteiltoleranzen und deren Auswirkungen auf die Alterung der Batterie 1 können folgende Parameterbeziehungen aufgestellt und bei der Ermittlung des Alterungszustands SoH anhand der Ermittlung des jeweiligen Alterungsfaktors AF berücksichtigt werden:
- Abweichung der Modulspannungen vom Mittelwert im Wakeup-Modus;
- Abweichung der Modulspannungen vom Mittelwert beim Laden;
- Abweichung der Modulspannungen vom Mittelwert beim Entladen.

Darüber hinaus können als weitere Parameter 5.n eine Ausgleichsladung, eine Rücksetzung des Alterungswertes berücksichtigt und in Beziehung mit anderen Parametern gesetzt werden. Auch eine Speicherung der maximalen Abweichung und eine Erhöhung des Ausgleichladungszählers können bei der Bestimmung des Alterungszustands SoH berücksichtigt werden.

Als weitere Parameter kann der Innenwiderstand der Batterie 1 anhand der Relation von Entladestrom und Spannung bestimmt werden. Auch kann die Kapazität C anhand der Relation von Ladeumsatz C_{NL} und Ladezustands-Änderung bestimmt werden.

Der anhand der einzelnen Alterungsfaktoren AF und/oder des Gesamt-Alterungsfaktors gAF ermittelte Alterungszustand SoH kann dabei differenziert ausgegeben werden. Je nach ermittelten Grad des Alterungszustands SoH wird an den Benutzer des Fahrzeugs eine entsprechende Meldung, z. B. abgestuft, wie folgt ausgegeben:
1. volle Funktionsfähigkeit,
2. Überprüfung der Batterie 1 beim nächsten Service empfohlen,
3. Service durchführen,
4. möglicher Ausfall.

Darüber hinaus kann in Abhängigkeit vom ermittelten Grad des Alterungszustands SoH mittels des Steuergeräts 4 eine Ausgleichsladung der Batterie 1 aktiviert werden, ein Laden und somit eine Erhöhung des Ladezustands SoC und/oder eine Einschränkung der Funktionalität der Batterie 1 durchgeführt werden. Im Falle eines sehr schlechten Zustands der Batterie kann diese auch nur noch für einen Impulsstart zur Verfügung gestellt werden.

Die Erfindung ist auf die hier beschriebenen Ausführungsbeispiele nicht begrenzt. So können weitere Parameter- oder Wertepaare für verschiedene Batterietypen gebildet werden. Im Falle der Verwendung eines Doppelschichtkondensators als wieder aufladbarer Speicher kann beispielsweise das Parameterpaar "Zellspannung" und "Kondensatortemperatur" das entscheidende Alterungskriterium sein (Dissoziation des Elektrolyten). Im Ruhemodus wird dieses Wertepaar zusätzlich mit einem Zeitparameter verknüpft.

### Bezugszeichenliste

- 1: Batterie
- 2: Batterie
- 3: Generator
- 4: Steuergerät
- 5.1 bis 5.n: Parameter
- 6.1: Hybridsteuergerät
- 6.2: Lüftersteuerung

- SoC: Ladezustand
- SoH: Alterungszustand
- SoF: Funktionsfähigkeit
- T: Temperatur
- C_{N}: Nennkapazität
- X1 bis Xn: Parameter-Klassen
- Y1 bis Ym: Parameter-Klassen
- W: Wichtungsfaktor
- Z: Zustandszähler

## Patentansprüche

1. Verfahren zur Bestimmung eines Alterungszustands (SoH) einer Batterie (1, 2), insbesondere einer Nickel-Metall Hydrid-Batterie für ein Fahrzeug, bei dem mehrere Parameter (5.1 bis 5.n) der Batterie (1, 2) erfasst und/oder bestimmt werden, wobei jeweils zwei von den Parameter (5.1, bis 5.n) als Parameterpaar (5.1 bis 5.n, 5.1 bis 5.n) vorgegeben und derart zueinander in Beziehung gesetzt werden, dass dem jeweiligen Parameter (5.1 bis 5.n) zugrunde liegende Parameterbereiche und daraus resultierende Wertepaare (X1, Y1 bis Xn, Ym) des vorgegebenen Parameterpaares (5.1 bis 5.n, 5.1 bis 5.n) klassifiziert gewichtet werden,
**dadurch gekennzeichnet, dass**
bei Vorliegen von aktuellen Istwerten, die einem der vorgegebenen Wertepaare (X1, Y1 bis Xn, Ym) entsprechen, ein dem betreffenden Wertepaar (X1, Y1 bis Xn, Ym) zugeordneter Zustandszähler (Z(X1, Y1) bis Z(Xn, Ym)) erhöht wird, und anhand des Wichtungsfaktors (W(X1, Y1) bis W(Xn, Ym)) und des Zustandszäihlers (Z(X1, Y1) bis Z(Xn, Ym)) für alle Wertepaare (X1, Y1 bis Xn, Ym) eines Parameterpaares (5.1 bis 5.n, 5.1 bis 5.n) ein einzelner Alterungsfaktor (AF) bestimmt wird.

2. Verfahren nach Anspruch 1, wobei ein jeder Parameter (5.1 bis 5.n) derart klassifiziert wird, dass dessen Parameterbereiche in eine vorgegebene Anzahl von Klassen (X1 bis Xn; Y1 bis Ym) unterteilt wird.

3. Verfahren nach Anspruch 1 oder 2, wobei einem jeden Wertepaar (X1, Y1 bis Xn, Ym) klassenbezogen ein Wichtungsfaktor (W(X1, Y1) bis W(Xn, Ym)) zugeordnet wird.

4. Verfahren nach Anspruch 3, wobei diejenigen Wertepaare (X1, Y1 bis Xn, Ym) mit einem hohen Wichtungsfaktor (W(X1, Y1) bis W(Xn, Ym)) als die Lebensdauer der Batterie (1, 2) beeinflussende Daten klassifiziert werden.

5. Verfahren nach Anspruch 3 oder 4, wobei diejenigen Wertepaare (X1, Y1 bis Xn, Ym) mit einem niedrigen Wichtungsfaktor (W(X1, Y1) bis W(Xn, Ym)) als funktionsrelevante Daten klassifiziert werden.

6. Verfahren nach einem der vorhergehenden Ansprüche, wobei der jeweilige Alterungsfaktor (AF) eines Parameterpaares (5.1 bis 5.n, 5.1 bis 5.n) gewichtet wird.

7. Verfahren nach Anspruch 6, wobei anhand der Summe der gewichteten einzelnen Alterungsfaktoren (AF) aller Parameterpaare (5.1 bis 5.n, 5.1 bis 5.n) ein Gesamt-Alterungsfaktor (gAF) für die Batterie (1, 2) bestimmt wird.

8. Verfahren nach Anspruch 7, wobei der oder die einzelnen Alterungsfaktoren (AF) und/oder der Gesamt-Alterungsfaktor (gAF) bei der Ermittlung des Alterungszustands (SoH) der Batterie (1, 2) berücksichtigt werden oder wird.

9. Verfahren nach Anspruch 8, wobei der Alterungszustand (SoH) bei der Ermittlung der Funktionsfähigkeit (SoF) der Batterie (1, 2) berücksichtigt wird.

10. Verfahren nach Anspruch 9, wobei der Alterungszustand (SoH), der Ladezustand (SoC) und/oder die Funktionsfähigkeit (SoF) einem Steuergerät (4) zugeführt werden.

11. Vorrichtung zur Bestimmung eines Alterungszustands (SoH) einer Batterie (1, 2), insbesondere einer Nickel-Metall-Hydrid-Batterie für ein Fahrzeug, umfassend einen Speicher (7), in welchem mehrere Parameter (5.1 bis 5.n) der Batterie (1, 2) derart hinterlegt sind, dass jeweils zwei von den Parametern (5.1 bis 5.n) als Parameterpaar (5.1 bis 5.n, 5.1 bis 5.n) zueinander in Beziehung gesetzt sind und dem jeweiligen Parameter (5.1 bis 5.n) zugrunde liegende Parameterbereiche und daraus resultierende Wertepaare (X1, Y1 bis Xn, Ym) des vorgegebenen Parameterpaares (5.1 bis 5.n, 5.1 bis 5.n) klassifiziert gewichtet sind,
**dadurch gekennzeichnet, dass**
einem jedem hinterlegten Wertepaar (X1, Y1 bis Xn, Ym) ein Zustandszähler (Z(X1, Y1) bis Z(Xn, Ym)) zugeordnet ist, der bei Vorliegen von aktuellen Istwerten, die einem der vorgegebenen Wertepaare (X1, Y1 bis Xn, Ym) entsprechen, erhöht wird.

12. Vorrichtung nach Anspruch 11, wobei für ein Parameterpaar (5.1 bis 5.n, 5.1 bis 5.n) mehrere Speichereinheiten (7 bis 10) vorgesehen sind.

13. Vorrichtung nach Anspruch 11 oder 12, wobei in einer ersten Speichereinheit eine einer vorgegebenen Anzahl von Klassen (x1 bis Xn, Y1 bis Ym) entsprechende Anzahl von Speicherfeldern für einen Parameter (5.1 bis 5.n) vorgesehen ist.

14. Vorrichtung nach einem der Ansprüche 11 bis 13, wobei in einer zweiten Speichereinheit für ein jeweiliges Parameterpaar eine Anzahl von Speicherfeldern für einen Wichtungsfaktor (W(X1, Y1) bis W(Xn, Ym)) vorgesehen ist.

## Claims

1. A method for determining the state of health (SoH) of a battery (1, 2), in particular of a nickel-metal hydride battery for a vehicle, in which method several parameters (5.1 to 5.n) of the battery (1, 2) are detected and/or determined, wherein two of said parameters (5.1 to 5.n) in each case are predefined as a pair of parameters (5.1 to 5.n, 5.1 to 5.n) and correlated with each other in such a manner that the parameter ranges on which each parameter (5.1 to 5.n) is based and value pairs (X1, Y1 to Xn, Ym) of the predefined pair of parameters (5.1 to 5.n, 5.1 to 5.n) resulting from said ranges are weighted in classes
**characterized in that**
if current actual values are available which correspond to any one of the predefined value pairs (X1, Y1 to Xn, Ym), a state counter assigned to the value pair (X1, Y1 to Xn, Ym) in question is increased, and the weighting factor (W(X1, Y1) to W(Xn, Ym)) and the state counter (Z(X1, Y1) to Z(Xn, Ym)) are used to determine an individual ageing factor (AF) for all value pairs (X1, Y1 to Xn, Ym) of a pair of parameters (5.1 to 5.n, 5.1 to 5.n).

2. A method according to claim 1, wherein each parameter (5.1 to 5.n) is classified in such a manner that its parameter ranges are divided into a predefined number of classes (X1 to Xn; Y1 to Ym).

3. A method according to claim 1 or 2, wherein a weighting factor (W(X1, Y1) to W(Xn, Ym)) is assigned to each value pair (X1, Y1 to Xn, Ym) according to its class.

4. A method according to claim 3, wherein those value pairs (X1, Y1 to Xn, Ym) having a high weighting factor (W(X1, Y1) to W(Xn, Ym)) are classified as data influencing the service life of the battery (1, 2).

5. A method according to claim 3 or 4, wherein those value pairs (X1, Y1 to Xn, Ym) having a low weighting factor (W(X1, Y1) to W(Xn, Ym)) are classified as functionally relevant data.

6. A method according to any one of the preceding claims, wherein the ageing factor (AF) of a pair of parameters (5.1 to 5.n, 5.1 to 5.n) is weighted in each case.

7. A method according to claim 6, wherein the sum of the weighted individual ageing factors (AF) of all pairs of parameters (5.1 to 5.n, 5.1 to 5.n) is used to determine a total ageing factor (gAF) for the battery (1, 2).

8. A method according to claim 7, wherein the individual ageing factor or factors (AF) and/or the total ageing factor (gAF) is or are taken into account when determining the state of health (SoH) of the battery (1, 2).

9. A method according to claim 8, wherein the state of health (SoH) is taken into account when determining the state of function (SoF) of the battery (1, 2).

10. A method according to claim 9, wherein the state of health (SoH), the state of charge (SoC), and/or the state of function (SoF) are supplied to a control device (4).

11. A device for determining the state of health (SoH) of a battery (1, 2), in particular of a nickel-metal hydride battery for a vehicle, comprising a memory (7) in which several parameters (5.1 to 5.n) of the battery (1, 2) are stored in such a manner that two of said parameters (5.1 to 5.n) in each case are correlated with each other so as to form a pair of parameters (5.1 to 5.n, 5.1 to 5.n), and the parameter ranges on which each parameter (5.1 to 5.n) is based and value pairs (X1, Y1 to Xn, Ym) of the predefined pair of parameters (5.1 to 5.n, 5.1 to 5.n) resulting from said ranges are weighted in classes
**characterized in that**
a state counter (Z(X1, Y1) to Z(Xn, Ym)) is assigned to each value pair (X1, Y1 to Xn, Ym) which has been stored, which counter is increased if current actual values are available which correspond to any one of the predefined value pairs (X1, Y1 to Xn, Ym).

12. A device according to claim 11, wherein several memory units (7 to 10) are provided for a pair of parameters (5.1 to 5.n, 5.1 to 5.n).

13. A device according to claim 11 or 12, wherein in a first memory unit, a number of memory fields for a parameter (5.1 to 5.n) is provided which corresponds to a predefined number of classes (X1 to Xn, Y1 to Ym).

14. A device according to any one of claims 11 to 13, wherein in a second memory unit, a number of memory fields for a weighting factor (W(X1, Y1) to W(Xn, Ym)) is provided for each pair of parameters.

## Revendications

1. Procédé de détermination d'un état de vieillissement (SoH) d'une batterie (1, 2), en particulier d'une batterie nickel-hydrure métallique pour un véhicule, dans lequel plusieurs paramètres (5.1 à 5.n) de la batterie (1, 2) sont détectés et/ou déterminés, deux des paramètres (5.1 à 5.n) étant prédéfinis respectivement en tant que paire de paramètres (5.1 à 5.n, 5.1 à 5.n) et mis en relation l'un par rapport à l'autre de sorte que des plages de paramètres fondant le paramètre respectif (5.1 à 5.n) et des paires de valeurs en résultant (X1, Y1 à Xn, Ym) de la paire de paramètres (5.1 à 5.n, 5.1 à 5.n) prédéfinie sont pondérées de façon classifiée,
**caractérisé en ce que**,
en présence de valeurs effectives actuelles qui correspondent à une des paires de valeurs (X1, Y1 à Xn, Ym) prédéfinies, un compteur d'état (Z(X1, Y1) à Z(Xn, Ym)) affecté à la paire de valeurs (X1, Y1 à Xn, Ym) concernée est augmenté, et un facteur de vieillissement (AF) individuel est déterminé à l'aide du facteur de pondération (W(X1, Y1) à W(Xn, Ym)) et du compteur d'état (Z(X1, Y1) à Z(Xn, Ym)) pour toutes les paires de valeurs (X1, Y1 à Xn, Ym) d'une paire de paramètres (5.1 à 5.n, 5.1 à 5.n).

2. Procédé selon la revendication 1, chaque paramètre (5.1 à 5.n) étant classifié de sorte que ses plages de paramètres sont divisées en un nombre prédéfini de classes (X1 à Xn ; Y1 à Ym).

3. Procédé selon la revendication 1 ou 2, un facteur de pondération (W(X1, Y1) à W(Xn, Ym)) étant affecté à chaque paire de valeurs (X1, Y1 à Xn, Ym) de façon spécifique aux classes.

4. Procédé selon la revendication 3, les paires de valeurs (X1, Y1 à Xn, Ym) ayant un facteur de pondération (W(X1, Y1) à W(Xn, Ym)) élevé étant classifiées en tant que données influençant la durée de vie des batteries (1, 2).

5. Procédé selon la revendication 3 ou 4, les paires de valeurs (X1, Y1 à Xn, Ym) ayant un facteur de pondération (W(X1, Y1) à W(Xn, Ym)) faible étant classifiées en tant que données pertinentes pour le fonctionnement.

6. Procédé selon une des revendications précédentes, le facteur de vieillissement (AF) respectif d'une paire de paramètres (5.1 à 5.n, 5.1 à 5.n) étant pondéré.

7. Procédé selon la revendication 6, un facteur de vieillissement global (gAF) étant déterminé pour la batterie (1, 2) à l'aide de la somme de différents facteurs de vieillissement (AF) individuels pondérés de toute les paires de paramètres (5.1 à 5.n, 5.1 à 5.n).

8. Procédé selon la revendication 7, le ou les différents facteurs de vieillissement (AF) et/ou le facteur de vieillissement global (gAF) étant pris en considération lors de la détermination de l'état de vieillissement de la batterie (1, 2).

9. Procédé selon la revendication 8, l'état de vieillissement (SoH) étant pris en considération lors de la détermination de la capacité opérationnelle (SoF) de la batterie (1, 2).

10. Procédé selon la revendication 9, l'état de vieillissement (SoH), l'état de charge (SoC) et/ou la capacité opérationnelle (SoF) étant conduits à un appareil de commande (4).

11. Dispositif de détermination d'un état de vieillissement (SoH) d'une batterie (1, 2), en particulier d'une batterie nickel-hydrure métallique pour un véhicule, comprenant une mémoire (7) dans laquelle plusieurs paramètres (5.1 à 5.n) de la batterie (1, 2) sont enregistrés de sorte qu'à chaque fois deux des paramètres (5.1 à 5.n) sont mis en relation l'un par rapport à l'autre en tant que paire de paramètres (5.1 à 5.n, 5.1 à 5.n), et des plages de paramètres fondant le paramètre respectif (5.1 à 5.n) et des paires de valeurs en résultant (X1, Y1 à Xn, Ym) de la paire de paramètres (5.1 à 5.n, 5.1 à 5.n) prédéfinie sont pondérées de façon classifiée,
**caractérisé en ce**
**qu'**un compteur d'état (Z(X1, Y1) à Z(Xn, Ym)) est affecté à chaque paire de valeurs (X1, Y1 à Xn, Ym) enregistrée et est augmenté en présence de valeurs effectives actuelles qui correspondent à une des paires de valeurs (X1, Y1 à Xn, Ym) prédéfinies.

12. Dispositif selon la revendication 11, plusieurs unités de mémoire (7 à 10) étant prévues pour une paire de paramètres (5.1 à 5.n, 5.1 à 5.n).

13. Dispositif selon la revendication 11 ou 12, un nombre de zones de mémoire pour un paramètre (5.1 à 5.n) correspondant à un nombre prédéfini de classes (x1 à Xn, Y1 à Ym) étant prévu dans une première unité de mémoire.

14. Dispositif selon une des revendications 11 à 13, un nombre de zones de mémoire pour un facteur de pondération (W(X1, Y1) à W(Xn, Ym)) étant prévu dans un deuxième unité de mémoire pour une paire de paramètres respective
